Europäisches Patentamt

European Patent Office

Office européen des brevets

(11) Publication number: **0 584 544 A1**

# EUROPEAN PATENT APPLICATION

(21) Application number: **93111851.7**

(22) Date of filing: **23.07.93**

(51) Int. Cl.5: **H03F 3/345**

(30) Priority: **24.07.92 JP 218232/92**
**27.07.92 JP 219712/92**

(43) Date of publication of application:
**02.03.94 Bulletin 94/09**

(84) Designated Contracting States:
**DE FR GB**

(71) Applicant: **YOZAN INC.**
**3-5-18, Kitazawa,**
**Setagaya-ku**
**Tokyo 155(JP)**

(72) Inventor: **Shou, Guoliang, c/o YOZAN Inc.**
**3-5-18, Kitazawa,**
**Setagaya-ku**
**Tokyo 155(JP)**
Inventor: **Takatori, Sunao, c/o YOZAN Inc.**
**3-5-18, Kitazawa,**
**Setagaya-ku**
**Tokyo 155(JP)**
Inventor: **Yamamoto, Makoto, c/o YOZAN Inc.**
**3-5-18, Kitazawa,**
**Setagaya-ku**
**Tokyo 155(JP)**

(74) Representative: **Patentanwälte Grünecker,**
**Kinkeldey, Stockmair & Partner**
**Maximilianstrasse 58**
**D-80538 München (DE)**

(54) **Operational amplifier.**

(57) An operational amplifier with a cascade of C-MOSs, the output of the final stage C-MOS is fed back to a gate of the first stage C-MOS. The plural number of voltage inputs and a feed back input are inputted through parallel coupling capacitances to the gate of the first stage C-MOS.

Figure 1

## FIELD OF THE INVENTION

The present invention relates to an operational amplifier, especially to voltage-driven type operational amplifier.

## BACKGROUND OF THE INVENTION

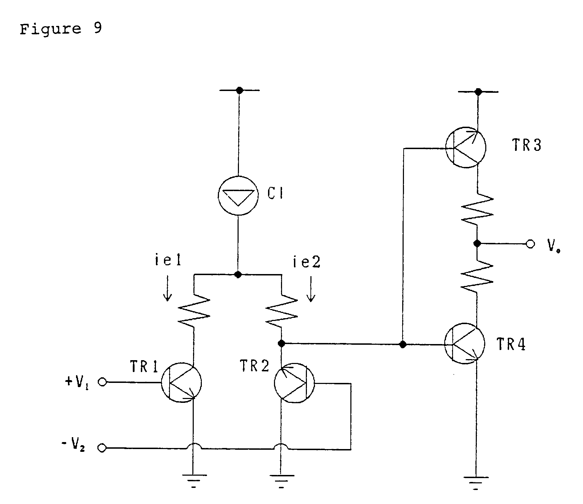

Conventional operational amplifier is driven by a current in response to an input voltage so as to output an output current. As figure 9 shows, constant voltage circuit CI keeps the total emitter current ie1 and ie2 constant of input side transistors TR1 and TR2 so that a calculation of addition or substraction is possible. Furthermore, it performs amplification by output side transistor TR3 and TR4. Here, TR1 and TR2 change their output voltage in response to current change, transistor TR3 and TR4 generates output voltage Vo caused by its collector current and emitter current. As a result, large amount of electric power is wasted during working.

## SUMMARY OF THE INVENTION

The present invention is invented so as to solve the problems above and has an object to provide an operational amplifier of low electric power.

An operational amplifier according to the present invention consists of a plurality of C-MOSs connected in a cascade, and an output of the final stage C-MOS is fed back to a gate of the first stage C-MOS.

## BRIEF DESCRIPTION OF THE DRAWINGS

Figure 1 shows a circuit of the first embodiment of an operational amplifier according to this invention.

Figure 2 shows a circuit of the second embodiment of the present invention.

Figure 3 shows a circuit of the third embodiment of the present invention.

Figure 4 is a circuit of the fourth embodiment of an operational amplifier.

Figure 5 is a standard voltage circuit in Figure 4.

Figure 6 is a circuit of the fifth embodiment.

Figure 7 is an input-output characteristic move of the action of C-MOS.

Figure 8 is another input-output characteristic move of C-MOS.

Figure 9 is a circuit of conventional operational amplifier.

## PREFERRED EMBODIMENT OF THE PRESENT INVENTION

Hereinafter, an embodiment of an operational amplifier relating to the present invention is described with referring to the attached drawings.

An operational amplifier includes C-MOSs m1 to m3 connected in a cascade, and input voltage $V_1$ and $V_2$ are inputted through condensers C1 and C2 on a gate of the first stage C-MOSm1. The result of addition of these input voltage $V_1$ and $v_2$ is to be an input voltage of C-MOS m1.

In order to correspond these input voltage to conventional $+V1$ and $-V2$, the minus voltage should be impressed to V2.

The output of C-MOSm1 is inputted to a gate of C-MOSm2, and the output of C-MOSm2 is inputted to a gate of C-MOSm3. This circuit improves the output sensitivity (that is, the rising power of an output is sharper). This is because the ratio between $\Delta V_{IN}$ of input change rate of a C-MOS $\Delta V_{OUT}$ of output change rate of it is sufficiently large substantially at the center of the range of the change (when drain voltage of pMOS is "$V_{DD}$" and source voltage of nMOS is "$-V_{SS}$", the above center is near the working range of $(V_{DD}-V_{SS})/2$).

That is $(\Delta V_{OUT}/\Delta V_{IN}) \gg 1$

$$[V_{OUT} \risingdotseq (V_{DD}-V_{SS})/2]$$

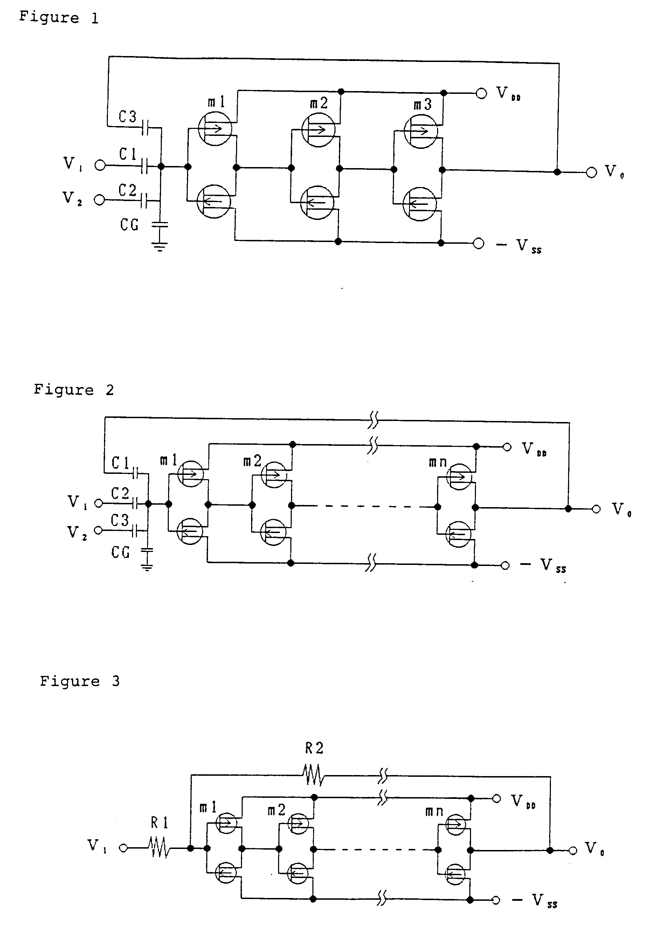

When these formulas are satisfied, it means that amplification effect is obtained, and amplification effect of the third stage is obtained by cascade connection in Figure 1.

Furthermore, an output of the final stage C-MOSm3 is fed back to a gate of the first stage C-MOSm1 through condenser C3 so that the gain is increased due to the positive feedback above.

Voltage input and feedback input to C-MOSmn are performed through condensers from C1 to C3, and the gate of C-MOSm1 is grounded through earth condensers CG. An effect of addition and substraction is obtained by condensers C1 to C3, and a reference electric voltage for each voltage is obtained by condenser CG.

Drain of pMOS is impressed positive voltage $V_{DD}$ and a source of nMOS is input negative voltage $V_{SS}$ with respect to C-MOSm1 to m3. Output range of each C-MOS is from $-V_{SS}$ to $+V_{DD}$.

In such a structure of a circuit, any electric current does not pass directly from $V_{DD}$ to $V_{SS}$ and only working current for charging or discharging the input capacitances is the consumptive electricity.

That means that an operational amplifier of voltage-driven type is obtained and electric consumption is economized in large scale, compared with conventional operational amplifier.

As will be easily understood from Figure 1, larger gain is obtained by connecting more amount of C-MOSm1 to mn in a cascade (Figure 2).

Figure 3 shows another embodiment of the present invention. In the embodiment, input voltage $V_1$ is inputted through input resistance R1 for a gate of C-MOSm1 on the first stage. The output of the C-MOSmn on the final stage is fed back to a gate of C-MOSm1 in the first stage. In this circuit, gain of $-(R2/R1)$ is obtained and its linearity is good. That is

Vo = - (R2/R1)$V_1$

In a circuit in Figure 3, an input voltage and a feedback voltage are inputted to the first stage C-MOS through a resistance, so it is not a complete voltage-driven type. However, compared with conventional operational amplifier, consumption current is spared in large scale because each C-MOS itself is voltage driven type.

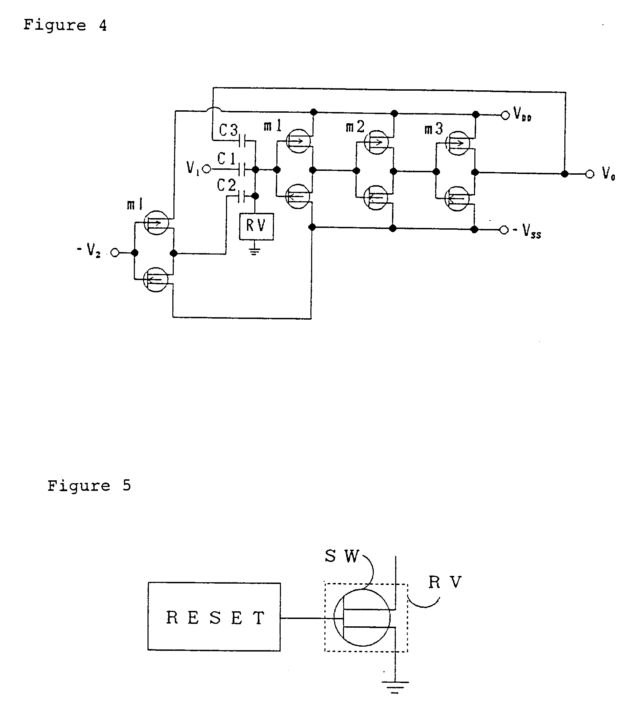

Figure 4 shows the fourth embodiment.

An operational amplifier includes C-MOSs m1 to m3 connected in a cascade, and input voltage $V_1$ and $V_2$ (subtractive element) are inputted through condensers C1 and C2 on a gate of the first stage C-MOSm1. The result of addition of these input voltage $V_1$ and $V_2$ is to be input voltage. In order to correspond these input voltage to conventional $+V_1$ and $-V_2$, $V_2$ should be connected to a condenser C2 through an inventor ml consisting of C-MOS.

Furthermore, a gate of the first stage C-MOSm1 is connected to a standard voltage circuit RV, and an unexpected voltage change by ion invaded to condensers from C1 to C3. This standard voltage circuit is driven when a whole circuit starts, and a gate voltage of the first stage C-MOS is settled at the predetermined value (It is usually settled by OV.)

A reference voltage circuit RV is composed like the manner in Figure 5, for example, and it grounds a switching element SW such as FET, etc. It is controlled by reset circuit RESET, and a gate of the first stage C-MOS is grounded.

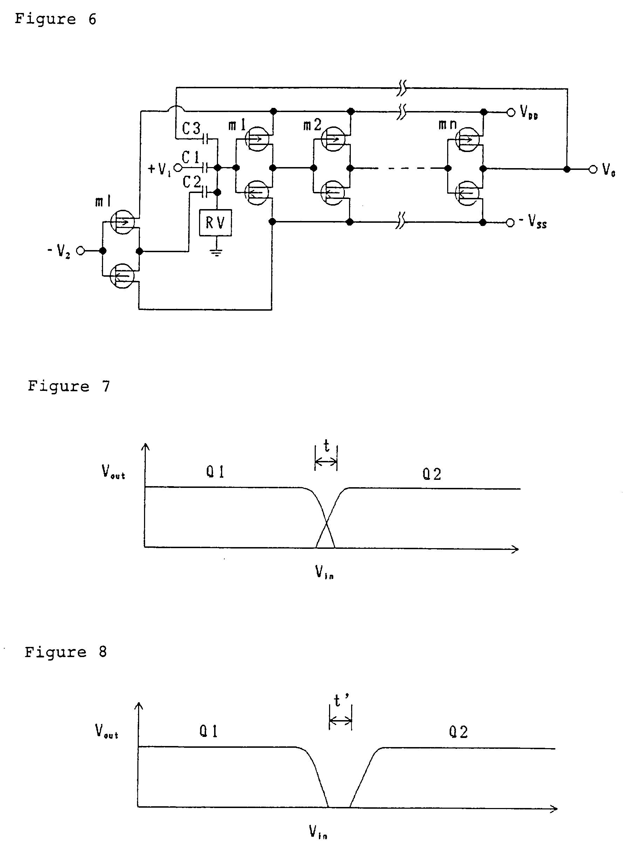

As shown in Figure 6, more C-MOSs can be connected in a cascade in order to increase the gain.

A C-MOS on the circuit mentioned above is composed by connecting compensatingly pMOS and nMOS, and nMOS controls it on behalf of pMOS according to the changes of the gate voltage. Figure 7 shows a graph, where an output voltage ($V_{OUT}$) is changed from a change depending on pMOS (Q1) to a change depending on nMOS (Q2). On the change, both action is partially overlapped (The period is shown by t.), and current directly flows from $V_{DD}$ to $V_{SS}$ during this period.

This current largely influences consumptive electricity. Here, as Figure 6, showing the characteristics of C-MOS, the consumptive electricity can be restrained by setting the characteristics of the C-MOS in order not to overlap Q1 and Q2 (A period t' of no action neither of Q1 and Q2 is settled.) However, the speed of the action of C-MOS becomes slow because of the settlement of the period t'. Then a characteristics of C-MOS should be settled considering the balance of consumptive electricity and speed of the action.

As mentioned above, an operational amplifier according to this invention has a great effect of large scale economization of consumption current because C-MOSs are connected in a cascade and the output of the final stage C-MOS is fed back to a gate of the first stage C-MOS.

Furthermore, an operational amplifier according to this invention realizes subtractive characteristics by impressing an input voltage through an inverter, and voltage compensation of input is performed by a reference voltage circuit.

## Claims

1.  An operational amplifier comprising a plurality of C-MOSs connected in a cascade, an output of the final stage C-MOS of said C-MOSs being fed back to a gate of the first stage C-MOS of said C-MOSs.

2.  An operational amplifier as claimed in Claim 1, wherein a plurality of voltage inputs are inputted in said gate of said first stage C-MOS.

3.  An operational amplifier as claimed in Claim 1, wherein said voltage inputted and fed back are connected through a set of parallel coupling capacitances to said gate of said first stage C-MOS.

4.  An operational amplifier as claimed in Claim 1, wherein said voltage inputs are connected through an input resistance in said gate of said first stage C-MOS and said output of said final stage C-MOS is input to said gate of said first stage C-MOS through a feedback resistance.

5.  An operational amplifier as claimed in Claim 3, wherein at least one of voltage inputs are connected to said condenser through an inverter.

6.  An operational amplifier as claimed in Claim 3, wherein said gate of said first stage C-MOS is connected to a reference voltage circuit.

7.  An operational amplifier claimed in Claim 1, wherein a timing for shifting to nMOS action from pMOS action in each C-MOS is set up according to a balance of consumptive electric power and characteristics of response of said operational amplifier.

Figure 1

Figure 2

Figure 3

Figure 4

Figure 5

Figure 6

Figure 7

Figure 8

Figure 9

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | INTERNATIONAL JOURNAL OF ELCTRONICS vol. 40, no. 3 , March 1976 pages 237 - 240 R.A. RIKOSKI ET AL 'A MICROPOWER COMPLEMENTARY-MOS DC AMPLIFIER' * page 239, paragraph 4 - page 240, line 8; figure 4 * | 1,4 | H03F3/345 |
| X | US-A-4 446 444 (R.B. PATTERSON) * column 4, line 33 - column 5, line 6; figure 4 * | 1 | |
| A | EP-A-0 114 314 (INTERSIL INC) * page 13, line 3 - page 14, line 13; figures 1,7 * | 2-6 | |
| A | PATENT ABSTRACTS OF JAPAN vol. 014, no. 008 (P-987)10 January 1990 & JP-A-01 258 188 (NEC CORP) 16 October 1989 * abstract * | 2-6 | TECHNICAL FIELDS SEARCHED (Int.Cl.5) H03F |

The present search report has been drawn up for all claims

| Place of search | Date of completion of the search | Examiner |
|---|---|---|
| THE HAGUE | 29 October 1993 | TYBERGHIEN, G |

EPO FORM 1503 03.82 (P04C01)